# EUROPEAN PATENT APPLICATION

(11) **EP 1 118 412 A1**
(43) Date of publication of application: **25.07.2001**
(21) Application number: 00127250.9
(22) Date of filing: 15.12.2000
(51) Int. Cl.: B23K 1/005

(54) **Method and device for soldering components on delicate support**

(30) Priority: 17.12.1999 FR 9916305
(71) Applicant: FRAMATOME CONNECTORS INTERNATIONAL, 92400 Courbevoie (FR)
(72) Inventor: Boudot, Cécile, 71510 Saint Berain sur dheune (FR); Duny, Pierre-Guy, 71670 Saint Pierre de Varennes (FR); Stricot, Yves, 78450 Villepreux (FR); Faure, Jean-Bernard, 78100 Saint Germain en Laye (FR); Cappe, Patrice, 28210 Faverolles (FR)
(74) Representative: Beetz & Partner Patentanwälte

(57) **Abstract**

Device and component soldering process (15) on flexible circuit (17), the components including soldering terminations (1) positioned on strip connection terminations (2) of the flexible circuit covered with soldering paste (3), the device including a laser (4) delivering heat spots calibrated by intensity and duration on the soldering terminations.

## Description

This invention relates to a soldering device for electronic and / or electrical components on delicate circuits and more particularly a method appropriate for flexible circuits with a weak resistance to high temperature.

Carry-over and soldering component methods and devices on rigid circuits are well known and for surface mounting components the techniques are for example infrared techniques or techniques for re-melting soldering paste. All these techniques expose the substrate to relatively high temperatures to activate the used soldering paste and are not adapted to the usual flexible circuits in polyester material.

The EP 0 804 990 A1 document teaches a carry-over and soldering technique for surface mounting components adapted to the flexible substrates commonly known as flexible circuits which possess a weak resistance to high temperatures.

This method consists of the following stages:
- placing a flexible substrate supplied with surface strip conductors on a support,
- placing a switch cover with openings on the support in such a way that the substrate is trapped between the switch cover and the support and forms a handling connection. The openings leave exposed the areas which are supposed to carry the carry-over components,
- application of a soldering paste on the areas of the strip conductors which are meant to receive the tabs or the soldering components terminations, whether before placing the switch cover or after,
- placing soldering components in a soldering position on the substrate,
- applying a first heating to the connection to preheat the soldering paste to a first temperature,
- higher heating of connection zones to melt the soldering paste and,
- cooling the connection so that the paste is solidified for it to adhere firmly to the terminations and the strip conductors.

In this document the method for raising the soldering paste at the first temperature is a radiating method, the support and the switch cover being provided with reflecting surfaces separated from the substrate in order to prevent raising the temperature of the substrate. This radiating method is based on a heating device with a gas float burner.

The support and the switch cover can be constructed in a material which conducts and resists heat to dissipate the heat separated from the substrate. Because of the support and switch cover systems the preheat heat is limited to 90 ° C at the level of the substrate while the heat obtained normally would be around 250 to 370 ° C.

This technique is well adapted to flexible circuits which have a melting temperature less than or equal to the second temperature typical of polyesters which have a contraction of less than 0,1 % for a temperature of 160 ° C. Nevertheless a better location and a greater precision in controlling and locating the fusion temperature of the paste is desirable to obtain a greater regularity of the solders. Moreover, using a gas stream could cause a misalignment of the soldering components.

In addition this technique causes a great loss of heat while obtaining the first temperature and depends on the speed of movement of the support under the radiating devices.

The German Patent DE 198 38 532 document teaches for its part the position of the solder on a substrate of solder balls using a placing gauge to deposit the balls and a laser to melt the balls in position.

The present invention relates to a process and a laser alternative device to obtain a welding in localised points mainly without a complex preheating device or in combination with a reduced preheating device, the device according to the present invention being adapted to flexible circuits not tolerating temperatures higher than 120° C.

To this end the present invention relates to a soldering device of soldering components, the components including soldering terminations positioned on strip connection terminations of the flexible circuit covered with soldering paste, the device being based on the use of an infrared laser delivering heat spots calibrated according to intensity and duration on the soldering terminations.

There is an advantage in the fact that the calibrated heat spots are obtained by a laser diode.

During an initial embodiment mode the position and surface of the spot are modifiable by a focusing device with an adjustable position which allows sequential embodiment of the soldering of several components.

In a special embodiment mode, the laser beam creating the spot can be controlled first of all to focus during the heating on irradiating a large zone of the termination and then focused to raise the temperature to the fusion point of the paste. The laser beam can also be power controlled, allowing a weak power supply to preheat the termination and then the soldering to be carried out by increasing the power.

The laser can be fixed and the controlled device capable of directing the laser beam on two perpendicular axes. Moreover the device can have, in relation to at least one laser, a number of light guides followed by focusing mechanisms relating to a number of soldering terminations.

In a special embodiment mode the flexible circuit is arranged on a support, the support being able to include a porous area allowing the flexible circuit to be flattened on the support by a suction device.

A complementary preheating device can be planned for the purpose of reducing the thermal shocks undergone by the substrate and components and avoiding any misalignment of the components in relation to the substrate during the melting of the paste.

The invention can also beneficially include the use of a local maintenance and support device for the components on the flexible circuit. This maintenance device can consist of a sensor and a support and component maintenance plate.

According to a special mode of the invention, a stripping plate element forms a shield consisting of ducts of the beam in combination with an enlargement of the beam allowing simultaneous soldering of several elements.

The reader will better understand the nature of the invention from the description of a non-limiting embodiment mode of invention which will follow in reference to the following Fig.:
- In Fig. 1 a view of the diagrammatic side of a device according to the invention,
- In Fig. 2 an example of a circuit with components in position,
- In Fig. 3 a device for multiple soldering according to an embodiment mode of the invention,
- In Fig. 4 a part of the device in Fig. 1 seen in perspective,

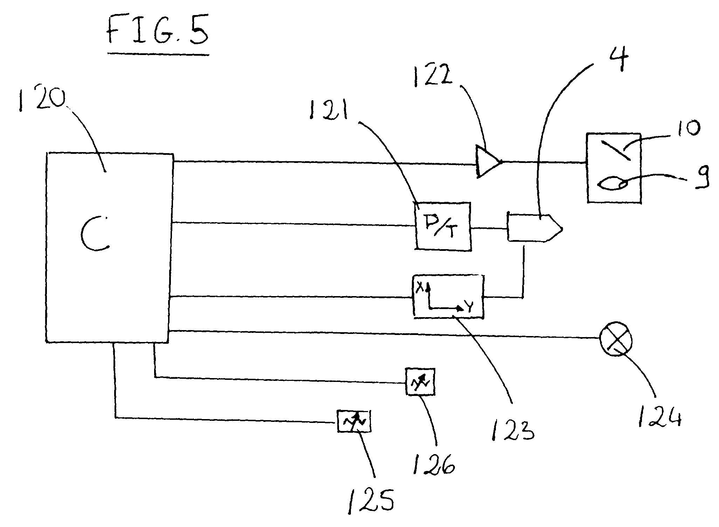

- In Fig. 5 a diagrammatic view of a piloting system of the device,
- In Fig. 6 a diagrammatic view in perspective of a connector with a shield according to an embodiment mode of the invention.

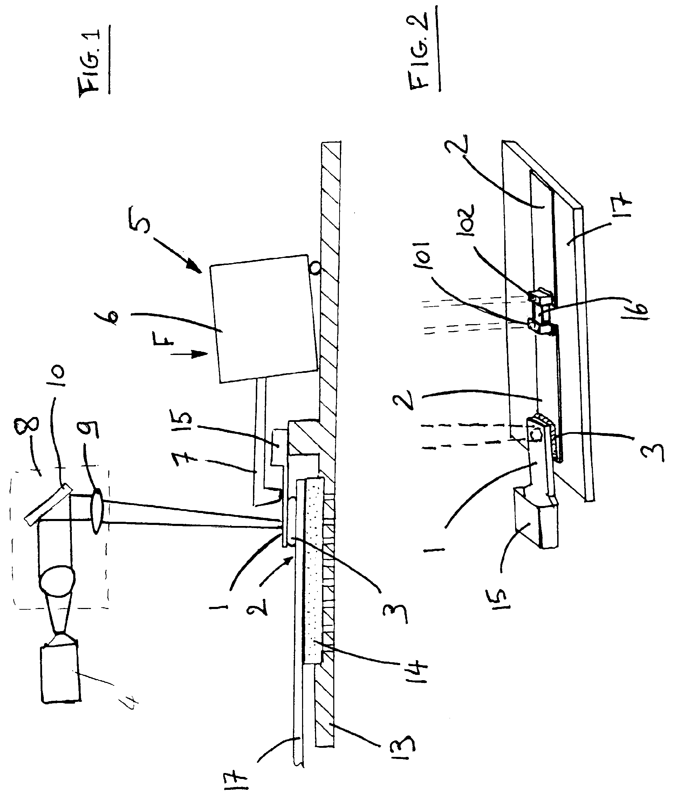

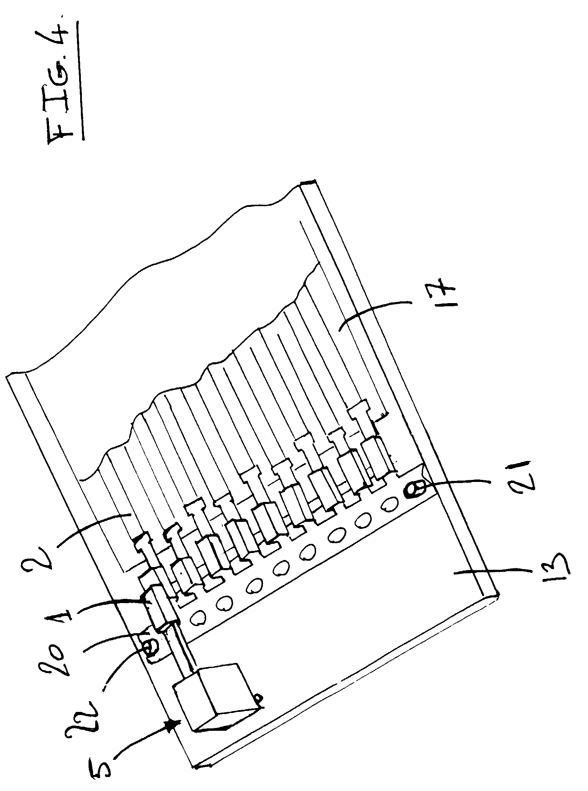

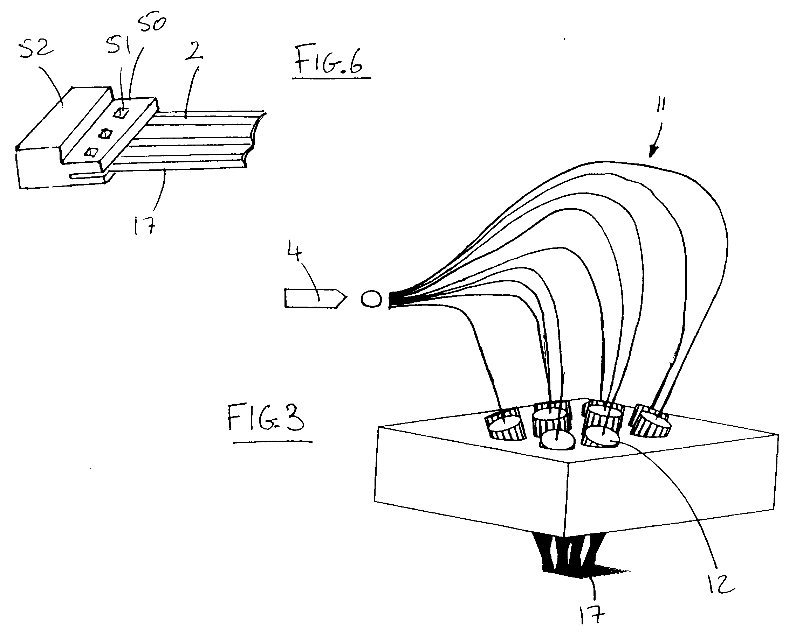

As in traditional techniques the soldering device uses a procedure based on the application of soldering paste (3) on parts (2) of strip conductors which are supposed to receive the lug or the soldering component terminations (1, 101, 102) to be connected electrically. For this, as can be seen in Fig. 1 and 4, the flexible circuit can be positioned on a support (13) serving to manipulate the flexible circuit and allowing its transport to the component soldering station. The support can include zones of porous material (14) permitting a suction device to coat the flexible circuit by suction on the support, preferably in the zones meant to receive the components. The components (15, 16) are then placed with their soldering termination (1, 101, 102) on the strip terminations (2) covered with soldering paste (3) by a placement arm or any other traditional device. For components such as electric contacts (15), they can either be provided with a carrier band (20) as can be seen in Fig. 3, or be arranged in units.

The sequential application of heat spots calibrated by duration, power and surface on the termination zones of the components located on the soldering paste is carried out by the laser device (4) which can be a pulsating infrared laser. Preferably the laser will be a diode laser. The application of heat spots can be done by laser heating of duration of between 1 and 5 seconds, the power of the heating can be regulated to between 0,5 mm² and some mm² in such a way as to solder a contact termination up to 4 x 5 mm. The laser can also be modulated in power to carry out a local preheating before the soldering stage.

The laser spot can also be enlarged and shaped into clearly rectangular bands which would allow, with the help of a stripping plate element forming a shield (50) covering the protected zones of the laser and possessing openings (51) at the level of zones which contain the connections, the soldering of several connections simultaneously. Particularly in the case of electric contacts the stripping plate can be an integral part of a connector bearing (52) represented in Fig. 6 receiving the contacts (15).

In the case of the use of a separate local maintenance and support device for components on the flexible circuit, this device (5), which can be seen in Fig. 1, can be made up of a sensor (6) provided with at least one support plate (7) on the component. The sensor can consist of several plates. These plates in a number corresponding to the number of components to be soldered are supported on the components in such a way as to improve the thermal contact between the soldering termination (1), the paste (3) and the strip termination (2). The plate can be fitted at the end of an articulated arm on a frame (6) which is itself over-mounted and likely to come to its aid by rotating on a reference plane to limit the movement of the plate and the supporting force and thus to keep the soldering termination flat compared to the strip termination.

The laser (4) can be adjustable and apply heat spots sequentially on the soldering terminations of the components, a controlling device (8) provided with focusing elements (9) and means of direction (10) of the spot being arranged opposite the laser to focus the heating on each of the terminations. The controlled device (8) is in this case capable of directing the laser beam on to two perpendicular axes. During the laser heating, the heat received by the soldering termination spreads through the soldering paste towards the strip termination, the temperature of the substrate of the flexible circuit remaining limited.

As an other embodiment the device can consist of several light guides (11) followed by focusing devices (12) opposite several soldering terminations. This device is suitable for carrying out several soldering simultaneously and in this event, the focusing devices (12) can be fixed in one place, directed towards each termination and regulated to optimise the desired spot surface. This method can be used particularly to solder electric contacts at the end of flexible circuits, the contacts being able to remain attached to their carrying band (20). Contacts provided with soldering terminations in different sections depending on the intensity of the current that they should support can thus be soldered simultaneously.

In order to optimise the power of the spots and increase the number of simultaneous soldering, several lasers can be used, each being coupled with several light guides. The flexible circuit (17) can be maintained on a transport support (13) either traditionally by centring pawns (21, 22) and there is an advantage in the fact that the support can have a porous area (14) allowing the flattening of the flexible circuit on the support by a suction device in order to increase the precision of the position of the strip terminations compared to the laser spot.

In order to limit thermal shocks a complementary preheating device such as in the previous section can be used. As an other embodiment this preheating device can use infrared lamps which are themselves controlled according to intensity and duration.

The spot can be controlled in focus during the heating to irradiate at first a large zone of the termination so that the paste can be preheated and dried and then focused to achieve the soldering.

A control device for the soldering process is attached to the device for the laser heating. This device is mainly made up of a calculator (120) guiding the calibration of the spots by duration and powered by a power unit (121) feeding the laser (4) and possibly a control unit (122) of a regulating, focusing device (9, 10). The duration of each spot is determined in such a way as to be adapted to raise the temperature either in every termination or on a number of terminations as a function of the dimensions of the soldering component. The spot can be defocused and then focused to gradually increase the temperature of the soldering.

The calculator also includes a component lead for controlling motors (123) guiding the positioning of the laser and possibly the movement of the circuit support.

This device, compared to the previous state of the art, particularly allows, in addition to the fixing of soldering joints on circuits with an even lower resistance to temperature, the removal of the heat dissipation switch cover or its replacement with a simple shield. Moreover this device, by its local action, permits the placing of supplementary components between several laser heating, the device being thus adaptable to an automatic carry over and placing station for components, the soldering operation being then combined with the placement operation.

## Claims

1. Soldering device for components, the components (15, 16) consisting of soldering terminations positioned on strip connection terminations (2) of a flexible circuit (17) covered with soldering paste (3), characterised by the fact that the device includes an infrared laser (4) delivering heat spots calibrated by intensity and duration on the soldering terminations, the position and surface of the heat spot are modifiable by a controlling device (8) consisting of an adjustable focusing and positioning device (8).

2. Device according to claim 1, characterised by the fact that the calibrated heat spots are made by a diode laser.

3. Device according to one of the claims 1 or 2, characterised by the fact that the spot is controlled in focus during the heating firstly to irradiate a large zone of the termination and then to be focused to raise the temperature to the fusion point of the paste.

4. Device according to one of the preceding claims, characterised by the fact that the laser is mobile.

5. Device according to one of the claims 1 to 3, characterised by the fact that the laser (4) is fixed and the controlled device (8) is capable of directing the laser beam on two perpendicular axes.

6. Device according to claim 5, characterised by the fact that a number of light guides (11) followed by focusing mechanisms (12) opposite a number of soldering terminations have been arranged opposite at least one laser (4).

7. Device according to one of the preceding claims, characterised by the fact that the laser has been power modulated.

8. Device according to any of the preceding claims, characterised by the fact that the flexible circuit is laid out on a support (13) which includes a porous part (14) permitting the flattening of the flexible circuit on the support by a suction device.

9. Device according to any of the preceding claims, characterised by the fact that it includes a complementary preheating device.

10. Device according to one of the preceding claims, characterised by the fact that it includes a local maintenance and support device (5) of components on the flexible circuit.

11. Device according to claim 10, characterised by the fact that the maintenance device (5) includes a sensor (6) and a maintenance and support plate (7) of the components.

12. Device according to one of the preceding patent claims, characterised by the fact that the laser beam is spread out and by the fact that a slipping plate forming a shield (50) is provided with ducts (51) from the beam to allow the soldering of several terminations simultaneously and the protection of the flexible circuit zones.

13. Device according claim 12, characterised by the fact that the slipping plate element is an integral part of a connector box (52), the terminations being contact terminations of the connector.

14. Soldering process of components on a flexible circuit, characterised by the fact that it includes a component placing stage, the components (15, 16) with soldering terminations (1, 101, 102) lying by means of soldering paste (3) on strip terminations (2) of flexible circuits, a stage of pressurised soldering terminations on the soldering paste and a stage of soldering terminations on the strip terminations by laser heating with a device according to one of the preceding claims.

15. Process according to claim 14, characterised by the fact that the components are supported by a band (20) cut off after the soldered stage.
